# EUROPÄISCHE PATENTSCHRIFT

(11) **EP 2 347 272 B1**
(45) Veröffentlichungstag und Bekanntmachung des Hinweises auf die Patenterteilung: **07.03.2018**
(21) Anmeldenummer: 09751834.4
(22) Anmeldetag: 14.10.2009
(51) Int. Cl.: G01R 31/28

(54) **ERMITTLUNG VON EIGENSCHAFTEN EINER ELEKTRISCHEN VORRICHTUNG**
DETERMINATION OF PROPERTIES OF AN ELECTRICAL DEVICE
DÉTERMINATION DES PROPRIÉTÉS D'UN DISPOSITIF ÉLECTRIQUE

(30) Priorität: 15.10.2008 AT 16202008
(43) Veröffentlichungstag der Anmeldung: 27.07.2011
(73) Patentinhaber: Xcerra Corp., Norwood MA 02062 (US)
(72) Erfinder: VOLPERT, Gilbert, 97877 Wertheim (DE); ROMANOV, Victor, 97877 Wertheim (DE)
(74) Vertreter: Ganahl, Bernhard
(86) Internationale Anmeldenummer: PCT/EP2009/063413
(87) Internationale Veröffentlichungsnummer: WO 2010/043651

(56) Entgegenhaltungen:
- EP-A1- 0 508 062
- EP-A1- 0 853 242
- EP-A2- 0 772 054
- WO-A1-2006/133808
- WO-A2-2006/008746
- DE-A1- 3 408 704
- DE-A1-102005 047 413
- DE-C1- 19 904 751
- US-A- 5 744 964
- US-A1- 2008 254 572

## Beschreibung

Die vorliegende Erfindung betrifft ein Verfahren zur Ermittlung elektrischer Eigenschaften einer elektrischen Vorrichtung, wobei das Verfahren folgende Schritte umfasst: Durchführen je einer Messung einer elektrischen Messgröße an mindestens einem herausgeführten elektrischen Anschluss eines jeden von mehreren Äquipotentialkörpern der elektrischen Vorrichtung.

Ein Beispiel für eine elektrische Vorrichtung deren elektrische Eigenschaften mit dem erfindungsgemäßen Verfahren zu ermitteln sind, ist beispielsweise in DE 199 04 751 C1 beschrieben. Unter einem Äquipotentialkörper wird hier ein Teil der elektrischen Vorrichtung verstanden, dessen Oberfläche zumindest dann eine Äquipotentialfläche bildet, wenn an der Äquipotentialfläche keine Wechselspannung und kein Wechselfeld angelegt werden. Dabei können der Äquipotentialkörper und damit auch seine Oberfläche teilweise oder vollständig in andere Teile der elektrischen Vorrichtung eingebettet sein, so dass es sich dann zumindest teilweise um eine von einer Umgebung der elektrischen Vorrichtung aus nicht sichtbare, interne Oberfläche des Äquipotentialkörpers handelt. Typischerweise ist der Äquipotentialkörper ein flächenartiges Gebilde, so dass dessen Längenausdehnung mindestens ein Hundertfaches, vorzugsweise ein Tausendfaches, seiner Dicke beträgt. Die einzelnen Äquipotentialkörper der elektrischen Vorrichtung können - im Vergleich zueinander - ganz unterschiedliche Formen aufweisen. Ein Äquipotentialkörper kann eine scheibenförmige, quaderförmige, schlangenförmige, spiralförmige, sternförmige, mehrfachsternförmige, netzförmige und/oder eine in anderer Weise verzweigte Gestalt aufweisen. Typischerweise besteht der Äquipotentialkörper aus einem dotierten Halbleiter oder aus einem Metall wie Kupfer, Silber, Gold oder Aluminium oder aus einer Metalllegierung. Unter "Anschluss" wird hier ein von einer Oberfläche der elektrischen Vorrichtung aus zugänglicher Teil des Äquipotentialkörpers verstanden.

Die EP 0 853 242 A1 beschreibt ein Verfahren zum Prüfen von Leiterplatten, wobei mehrere Netze einer Leiterplatte kurzgeschlossen werden und die miteinander kurzgeschlossenen Netze gegenüber weiteren Netzen gemeinsam auf Kurzschluss getestet werden.

In der EP 0 508 062 A1 wird eine Feldmessmethode definiert, bei der eine Leiteranordnung mit einem elektrischen Feld beaufschlagt wird und mindestens ein aufgrund des elektrischen Feldes sich in der Leiteranordnung bildendes elektrisches Potential von Messsonden an den einzelnen Prüfpunkten abgenommen wird und mit dem Potential anderer Prüfpunkte und/oder mit einer Referenz verglichen wird.

Die EP 0 772 054 A2 offenbart ein Verfahren, bei dem zunächst in einem ersten Messvorgang eine erste Leiteranordnung mittels einer Feldmessung untersucht wird, wobei anhand der Feldmessung komplexe Leitwerte für die einzelnen Netze bestimmt werden. In den nachfolgenden Messvorgängen weiterer Leiteranordnungen werden die komplexen Leitwerte der Leiterbahnen gemessen und mit den zuvor bestimmten komplexen Leitwerten verglichen.

Die WO 2006/133808 A1 betrifft ein Verfahren, bei dem unbestückte, großflächige Leiterplatten mit einem Fingertester getestet werden. Gemäß diesem Verfahren werden die Leiterplatten in mehrere Segmente unterteilt getestet, wobei Leiterbahnen, die sich über ein Segment hinaus erstrecken, mittels kapazitiver Messung der in dem jeweiligen Segment befindlichen Endpunkte getestet werden.

Aus der US 5,744,964 geht eine Vorrichtung zum Messen von Leiteranordnungen hervor, wobei die einzelnen Netze der Leiteranordnungen mittels einer Widerstandsmessung oder einer Kapazitätsmessung gemessen werden können. Bei der Kapazitätsmessung werden zwei voneinander unabhängige Netze jeweils mit einer Testsonde kontaktiert und die Kapazität zwischen diesen beiden Testsonden wird gemessen.

In der DE 34 08 704 A1 wird eine Vorrichtung zum Testen von Schaltungsanordnungen beschrieben, bei welcher Netze der Schaltungsanordnung mittels einer kapazitiver Messung untersucht werden. Die kapazitive Messung erfolgt bezüglich einer leitfähigen Platte, die von der Schaltungsanordnung mittels einer dielektrischen, isolierenden Platte getrennt ist.

Des Weiteren betrifft die vorliegende Erfindung eine Vorrichtung zur Ermittlung elektrischer Eigenschaften einer elektrischen Vorrichtung.

Bei den konventionellen Verfahren nimmt die Überprüfung einer Fehlerfreiheit von Äquipotentialflächen elektrischer Vorrichtungen sehr viel Zeit in Anspruch, so dass ein Durchsatz der aufwendigen Messvorrichtung bzw. deren Wirtschaftlichkeit begrenzt ist.

Es ist eine Aufgabe der vorliegenden Erfindung, einen Durchsatz der einzelnen Messvorrichtung ohne kostenaufwendige Erhöhung des apparativen Aufwands zu verbessern.

Diese Aufgabe wird mit den Merkmalen der unabhängigen Ansprüche 1 und 15 gelöst.

Vorteilhafte Ausführungsformen der Erfindung sind in den abhängigen Ansprüchen angegeben.

Die Erfindung baut auf einem gattungsgemäßen Verfahren zur Ermittlung elektrischer Eigenschaften einer gattungsgemäßen elektrischen Vorrichtung dadurch auf, dass die Messung der elektrischen Messgröße bestimmter Äquipotentialkörper an zumindest einem anderen herausgeführten elektrischen Anschluss des jeweiligen Äquipotentialkörpers nicht durchgeführt wird, wenn ein gegebenenfalls zu erkennender Fehler des jeweiligen Äquipotentialkörpers im Bereich dieses anderen Anschlusses die elektrische Messgröße stärker beeinflusst als eine Toleranz der Messung dieser Messgröße beträgt.

Dies bedeutet, dass die Messung der elektrischen Messgröße bestimmter Äquipotentialkörper an zumindest einem anderen herausgeführten elektrischen Anschluss des jeweiligen Äquipotentialkörpers nur durchgeführt wird, wenn ein gegebenenfalls zu erkennender Fehler des jeweiligen Äquipotentialkörpers im Bereich dieses anderen Anschlusses die elektrische Messgröße nicht stärker beeinflusst als eine Toleranz der Messung dieser Messgröße beträgt. Es werden somit nur alle weiteren Anschlüsse eines bestimmten Äquipotentialkörpers gemessen, deren potentieller minimaler Fehler kleiner als die Toleranz einer vorhergehenden Messung der elektrischen Messgröße an diesem Äquipotentialkörper ist.

Die potentiellen minimalen Fehler, die an bestimmten Anschlüssen des Äquipotentialkörpers gemessen werden können, sind an einzelnen ohne mit dem Äquipotentialkörper verbunden Anschlüssen messbar oder anhand von CAD-Daten und Materialdaten berechenbar bzw. abschätzbar. Sie liegen somit für bestimmte Typen von Anschlüssen vor.

Die prozentuale Messfehler der Messung ist dem Fachmann bekannt und hängt von der verwendeten Messelektronik ab. Die Toleranz für einen bestimmten Äquipotentialkörper ergibt sich aus dem Soll-Wert der Messgröße für den jeweiligen Äquipotentialkörper und dem prozentualen Messfehler. Die Soll-Werte der Messgrößen der einzelnen Äquipotentialkörper werden bspw. vorab an einer fehlerfreien elektrischen Vorrichtung ermittelt. Hieraus können die Toleranzen der einzelnen Äquipotentialkörper ermittelt werden. Diese liegen somit bei Durchführung des Verfahrens vor.

Vor dem Durchführen einer Messung an einem weiteren Anschluss wird geprüft, ob an diesem Anschluss eine Messung weggelassen werden kann. Da die entsprechenden Werte für die Toleranzen und den potentiellen minimalen Fehlern in der Regel bereits vor Durchführung des Verfahrens vorliegen, kann diese Prüfung vor der Durchführung der ersten Messung der Messgrößen aller Äquipotentialkörper erfolgen. Vorzugsweise wird beim Erstellen eines Prüfablaufes, in dem festgelegt ist, welche Anschlüsse in welcher Reihenfolge gemessen werden, diese Prüfung ausgeführt, so dass dann ein solcher Prüfablauf mit wesentlich weniger Messungen als im Stand der Technik abgearbeitet werden kann.

In einer bevorzugten Ausführungsform wird eine Höhe der Beeinflussung der elektrischen Messgröße während einer Durchführung des Verfahrens mittels Messungen an einer vorzugsweise repräsentativen Anzahl von gleichartigen elektrischen Vorrichtungen statistisch ermittelt.

In einer weiteren bevorzugten Ausführungsform wird eine für die Messungen zugrundezulegende Messtoleranz mittels einer Eichmessung an mindestens einem Äquipotentialkörper mit beispielhaften Abmessungen ermittelt.

Außerdem ist es vorteilhaft, wenn zunächst erste Messungen unter Zugrundelegung einer Anfangsmesstoleranz durchgeführt werden und für nachfolgende Messungen eine aus den ersten Messungen statistisch ermittelte Messtoleranz zugrundegelegt wird.

Gemäß einer vorteilhaften Weiterbildung des erfindungsgemäßen Verfahrens wird während einzelner Messungen jeweils zwischen zwei oder mehr Äquipotentialkörpern mittels eines elektrischen Bauelements eine temporäre elektrische Verbindung hergestellt und an den jeweils temporär elektrisch verbundenen Äquipotentialkörpern eine gemeinsame Messung durchgeführt.

Insbesondere ist eine Ausführungsform vorteilhaft, in der das elektrische Bauelement im Wesentlichen eine elektrische Leitung bildet.

Die Messungen können Leitwert- und/oder Kapazitäts- und/oder Laufzeitmessungen und/oder elektrische Feldmessungen und/oder magnetische Feldmessungen und/oder elektromagnetische Feldmessungen umfassen.

In einer ebenfalls bevorzugten Ausführungsform umfassen die Messungen eine Messung eines Betrags, eines Winkels, eines Realteils und/oder eines Imaginärteils eines Vierpolparameters der Leitwertform, der Widerstandsform, der Kettenform und/oder der Hybridform.

In einer weiteren Ausführungsform wird ein Sollwert eines Messwerts der Messung und/oder eine Toleranz des Messwerts der Messung während einer Durchführung des Verfahrens mittels Messungen an einer vorzugsweise repräsentativen Anzahl von gleichartigen elektrischen Vorrichtungen statistisch ermittelt.

Die elektrische Vorrichtung kann während der Messung zumindest zeitweise und zumindest raumabschnittsweise einem elektrischen, einem magnetischen und/oder einem elektromagnetischen Feld ausgesetzt werden.

In einer besonders bevorzugten Ausführungsform ist das Feld ein inhomogenes Feld und/oder ein zumindest zeitweise stationäres Feld und/oder ein zumindest zeitweise nichtstationäres Feld.

Vorzugsweise wird mindestens einer der Äquipotentialkörper der elektrischen Vorrichtung an eine Strom- oder Spannungsquelle angeschlossen, um das elektrische und/oder elektromagnetische Feld zu erzeugen.

In einer weiteren bevorzugten Ausführungsform ist eine Höhe der Beeinflussung der elektrischen Messgröße von einer Volumenausdehnung und/oder von einer Flächenausdehnung und/oder von einer Längenausdehnung und/oder von einer spezifischen Leitfähigkeit und/oder von einer Kontaktstellenzahl und/oder von einer Prüfpunktzahl und/oder von einer Bohrungszahl des jeweiligen Äquipotentialkörpers und/oder von einem den jeweiligen Äquipotentialkörper umgebenden Material abhängig.

Die erfindungsgemäße Vorrichtung baut auf einer gattungsgemäßen Vorrichtung dadurch auf, dass sie die elektrischen Eigenschaften der elektrischen Vorrichtung mittels des erfindungsgemäßen Verfahrens ermittelt.

Die Erfindung wird nachfolgend anhand von Ausführungsbeispielen näher erläutert. Die Ausführungsbeispiele sind in den beigefügten Zeichnungen dargestellt. Die Zeichnungen zeigen in:
- Figur 1: ausschnittweise einen nicht maßstäblichen Querschnitt einer beispielhaften elektrischen Vorrichtung, von der mittels des erfindungsgemäßen Verfahrens elektrische Eigenschaften ermittelt werden können;
- Figur 2: eine nicht maßstäbliche Aufsicht auf die beispielhafte elektrische Vorrichtung, von der mittels des erfindungsgemäßen Verfahrens elektrische Eigenschaften ermittelt werden können;
- Figur 3: einen Querschnitt durch eine beispielhafte Messvorrichtung zum Durchführen von Messungen einer elektrischen Messgröße an einer der beispielhaften elektrischen Vorrichtungen;
- Figur 4: ein beispielhaftes Ablaufdiagramm zur Erläuterung des erfindungsgemäßen Verfahrens zur Ermittlung elektrischer Eigenschaften mehrerer elektrischer Vorrichtung, wie sie im Folgenden anhand der Figuren 1 und 2 beschrieben sind;
- Figur 5: ein Ersatzschaltbild zur Erläuterung eines ersten Konzepts des erfindungsgemäßen Verfahrens am Beispiel einer Zweipolmessung;
- Figur 6: ein Ersatzschaltbild zur Erläuterung eines zweiten Konzepts des erfindungsgemäßen Verfahrens am Beispiel einer Zweipolmessung;
- Figuren 7 und 8: Beispiele für Messanordnungen mit Vierpolmessungen, wobei ein elektrisches Eingangsfeld mittels einer Messspannungsquelle erzeugt wird und eine elektrische Potentialdifferenz mittels eines Spannungsmessgeräts erfasst wird; und
- Figuren 9 und 10: Beispiele für Messanordnungen mit Vierpolmessungen, wobei der Vierpol als magnetisch gekoppelter Hochfrequenzübertrager betrieben wird.

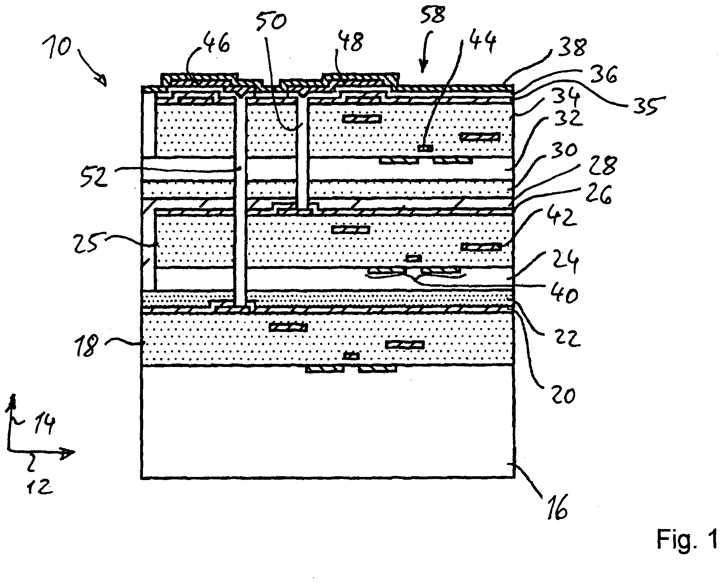

Die Figur 1 zeigt ausschnittsweise einen nicht maßstäblichen Querschnitt einer integrierten Schaltung 10, die in einer horizontalen 12 und einer vertikalen Richtung 14, also dreidimensional integriert ist. Eine solche integrierte Schaltung 10 wurde beispielsweise in DE 199 04 751 C1 beschrieben. Hierbei sind auf einem Substrat 16 mehrere Materialschichten 18, 20, 22, 24, 25, 26, 28, 30, 32, 34, 35, 36, 38 aufgeklebt, auflaminiert, aufgeschmolzen, aufgelötet und/oder aufgesintert. In dem in der Figur gezeigten Beispiel wechseln sich Schichten 18, 20, 22, 24, 25, 26, 28, 30, 32, 34, 35, 36, 38 unterschiedlichen Materials ab. Typischerweise sind zwischen nichtleitenden Schichten 18, 22, 24, 25, 28, 30, 32, 34, 36, 38 leiterbahnartige Äquipotentialkörper 20, 26, 35, 40, 42, 44 angeordnet, mit denen elektrische Verbindungen zwischen Anschlüssen von bereits in der integrierten Schaltung 10 integrierten elektrischen Bauelementen und/oder zwischen Anschlüssen 46, 48 von an der integrierten Schaltung 10 noch anzuordnenden elektrischen Bauelementen hergestellt werden. Die nichtleitenden Schichten 18, 22, 24, 25, 28, 30, 32, 34, 36, 38 haben typischerweise dieelektrische Eigenschaften, erfüllen also die Funktion von zwischen Äquipotentialkörpern 20, 26, 35, 40, 42, 44 angeordneten Dieelektrika. Typischerweise sind in der integrierten Schaltung 10 Durchkontaktierungen 50, 52 vorgesehen, mit denen je nach Anwendung bedarfsabhängig elektrische Verbindungen zwischen den unterschiedlichen Äquipotentialkörpern 20, 26, 35, 40, 42, 44 hergestellt werden. Ein Vorzug der in der Figur dargestellten integrierten Schaltung 10 besteht darin, dass eine Durchkontaktierung zwischen nicht direkt benachbarten Äquipotentialkörpern 20, 35 keine (genauer: "nicht notwendigerweise eine") elektrische Verbindung mit einem der zwischen den nicht direkt benachbarten Äquipotentialkörpern 20, 35 angeordneten Äquipotentialkörper 26, 40, 42, 44 bedingt.

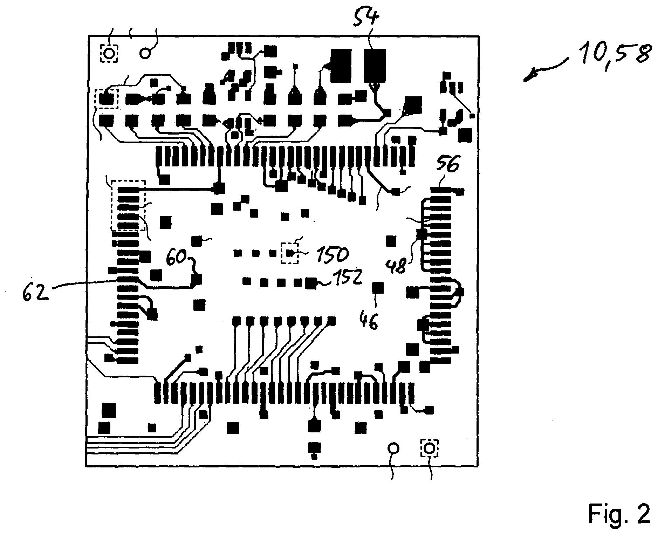

Figur 2 zeigt eine nicht maßstäbliche Aufsicht auf die beispielhafte elektrische Vorrichtung 10 von Figur 1, von der mittels des erfindungsgemäßen Verfahrens 103 elektrische Eigenschaften ermittelt werden können. Die Vorrichtung 10 weist in einer zuoberst oder fast zuoberst liegenden Schicht leiterbahnähnliche Äquipotentialkörper 54, 56 mit Anschlüssen auf. Auch die Durchkontaktierungen 50, 52 weisen in der Regel jeweils eine an eine Außenseite 58 der elektrischen Vorrichtung 10 herausgeführte Kontaktierungsstelle 46, 48 auf. Da die Durchkontaktierungen 50, 52 für elektrischen Strom leitfähig sind, stellen sie ebenfalls Äquipotentialkörper dar. Somit bildet jeder Äquipotentialkörper 20, 46 bzw. 26, 48, von dem eine oder mehrere Durchkontaktierungen 52 bzw. 50 zu einer Oberfläche 58 der elektrischen Vorrichtung 10 herausgeführt ist, mit dem bzw. den Durchkontaktierungen 52 bzw. 50 einen gemeinsamen Äquipotentialkörper 20, 46, 52 bzw. 26, 48, 50. Die Äquipotentialkörper 20, 46, 52 bzw. 26, 48, 50 können diverse Defekte aufweisen, die mittels des erfindungsgemäßen Verfahrens 103 besonders zeiteffizient und ressourcenschonend erfasst werden können. Beispielsweise können zwei Äquipotentialkörper 20, 46, 52 bzw. 26, 48, 50 in unbeabsichtigter Weise mittels eines leitenden Fremdkörpers, wie beispielsweise eines Lotrests oder eines Metallspans, miteinander elektrisch, d.h. leitend verbunden sein. Eine andere Art von Defekt besteht darin, wenn nicht alle Teile eines (geplanten) Äquipotentialkörpers 20, 46, 52 bzw. 26, 48, 50 elektrisch leitend miteinander verbunden sind. In diesem Fall stellen die Teile eines geplanten einzelnen Äquipotentialkörpers 20, 46, 52 bzw. 26, 48, 50 in Realität mehr als einen Äquipotentialkörper 20, 46, 52 bzw. 26, 48, 50 dar.

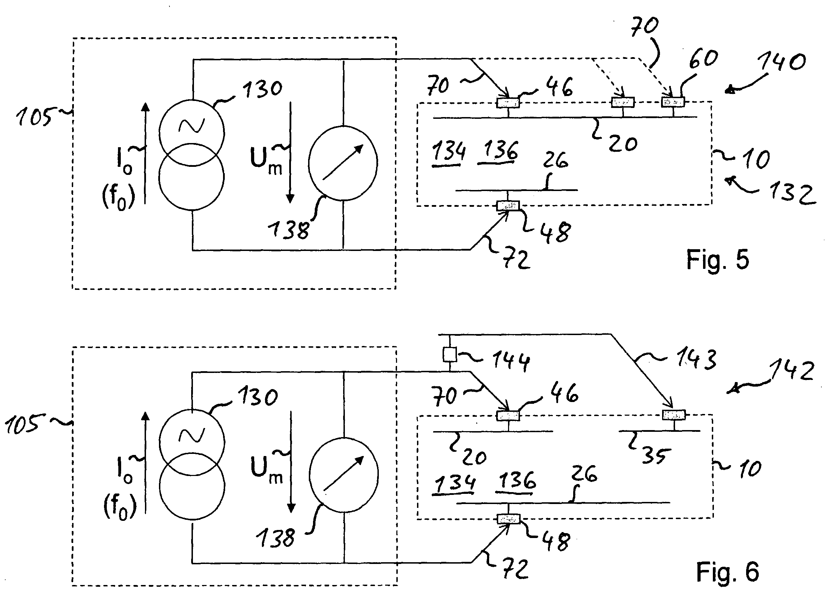

Aus Platzgründen, aus elektrischen Gründen und/oder aus Aufwandsgründen kann es zumindest unerwünscht sein, vom Ende 60 eines jeden Astes eines sternartig verzweigten Äquipotentialkörpers 62 zu Messzwecken je einen Anschluss an eine Oberfläche 58 der elektrischen Vorrichtung 10 herauszuführen. Aus diesen und aus anderen Gründen ist es daher vorteilhaft, eine Kapazitätsmessung zwischen jeweils zwei direkt oder mittelbar benachbarten Äquipotentialkörpern 20, 26 durchzuführen. Hierzu kann an beide Äquipotentialkörper 20, 26 eine Wechselspannung angelegt werden, um dann den aus dieser Messanordnung resultierenden Strom zu messen. Eine andere in den Figuren 5 und 6 dargestellte Möglichkeit besteht darin, in die Kapazität C, die die beiden Äquipotentialkörper 20, 26 miteinander bilden, einen Wechselstrom lₒ einzuprägen, um dann die anliegende Spannung Um zu messen. Bei Verwendung einer Messspannungs- oder Messstromquelle mit einem definierten Innenwiderstand ist sozusagen auch eine Zwischenlösung durchführbar, um auf eine Kapazität C, die zwischen den Äquipotentialkörpern 20, 26 besteht, zu schließen. Damit die Kapazität C zwischen den Äquipotentialkörpern 20, 26 auf das Messergebnis eine Wirkung hat, die ausreichend deutlich unterscheidbar von einer räumlichen Ausdehnung des Äquipotentialkörpers 20, 26 abhängt, sollte zur Messung eine Messwechselspannung Um bzw. Messwechselstrom lₒ mit einer umso höheren Messfrequenz fₒ verwendet werden, je geringer die Kapazität C ist, die die beiden Äquipotentialkörper 20, 26 miteinander bilden. Bei Äquipotentialkörperstrukturen mit wenigen Zentimetern oder gar Millimetern Ausdehnung werden zur Messung Messwechselspannungen bzw. Messwechselströme lₒ im Hochfrequenzbereich benutzt. Je höher die Messfrequenz fₒ ist, umso mehr ist die Ausbreitungsgeschwindigkeit in Richtung eines Pointingvektors der elektromagnetischen Welle zwischen den beiden Äquipotentialkörpern 20, 26 auf die Messung von Bedeutung. Mit anderen Worten: Die Kapazitätsmessung wird zunehmend zu einer Hochfrequenzmessung an einem Wellenleiter 132, der aus den beiden Äquipotentialkörpern 20, 26 und ihrer Umgebung besteht. Da an den Ausläufern 60 der Äquipotentialkörper 20, 26, an Verzweigungsstellen derselben und an Breiten-, Dicken-, Abstandsänderungen und/oder Kurzschlüssen der Äquipotentialkörper 20, 26 charakteristische Wellenreflektionen auftreten, kann eine Intaktheit der Äquipotentialkörper 20, 26 auch mittels einer Reflektometer-Laufzeitmessung festgestellt werden. Allerdings sind solche Messungen im Zeitbereich technisch aufwendig. Einfacher können hier Messungen im Frequenzbereich sein. Beispielsweise können an das Paar von Äquipotentialkörpern 20, 26 Wechselspannungen mindestens zwei unterschiedlicher Frequenzen fₒ aus einem Hochfrequenzbereich angelegt werden. Oder es kann das Verhalten der Äquipotentialkörperanordnung 20, 26 mittels eines Wobblers oder mittels Impulsen oder periodischen Signalen mit hochfrequenten Anteilen festgestellt werden. Oder es kann mittels eines Rauschgenerators 160 an die Äquipotentialkörperanordnung 20, 26 ein hochfrequentes Rauschen angelegt werden, um dann mittels eines Spektralanalysators 162 ein Vorhandensein charakteristischer Resonanzen zu überprüfen, die infolge von Wellenreflektionen den Ausläufern 60 der Äquipotentialkörper 20, 26, an Verzweigungsstellen derselben und an Breiten-, Dicken- und/oder Abstandsänderungen der Äquipotentialkörper 20, 26 auftreten.

Unabhängig davon, welches der erwähnten Verfahren zur Kapazitätsmessung angewendet wird, kann mit dem Kapazitäts- und/oder Reflektions- und/oder Resonanzmessverfahren nicht nur eine Unterbrechung in einem der beiden Äquipotentialkörper 20, 26, sondern auch ein Kurzschluss zwischen den beiden Äquipotentialkörpern 20, 26 festgestellt werden. Wenn man die Äquipotentialkörperanordnung 20, 26 aus Niederfrequenzsicht betrachtet, führt ein Kurzschluss auch für eine Messwechselspannung bzw. den Messwechselstrom lₒ im Prinzip zu einem unendlich niedrigen elektrischen Widerstand, also zu einem unendlich hohen Leitwert. Dies gilt auch für den Blindanteil, also den Scheinwiderstand zwischen den beiden Äquipotentialkörpern 20, 26. Bis hierhin wurden die Äquipotentialkörperanordnung 20, 26 noch als Zweipol mit den jeweils zwei zur Messung benutzten Anschlüssen 46, 48 betrachtet. Sofern für die Messung ein weiterer Anschluss 60 verwendet wird, sind in der oben beschriebenen Weise auch Wechsel- oder Hochfrequenz-Vierpolmessungen möglich. Die Anordnung mit den beiden Äquipotentialkörpern 20, 26, 60 bildet dann eine Art Hochfrequenzübertrager. Bei einer solchen Vierpolmessung kann sogar einer der beiden Äquipotentialkörper ein externer Äquipotentialkörper 166, 168 sein, der kein Teil der elektrischen Vorrichtung 10 ist.

Da es insbesondere bei unregelmäßig geformten Äquipotentialkörpern 20, 26 schwierig ist, die Zweipol- oder Vierpolsolleigenschaften zu berechnen, ist folgendes Verfahren zur Gewinnung von Sollwerten zielführender. Hierzu werden die Zweipol- beziehungsweise die Vierpoleigenschaften an einer kleinen Zahl von beispielsweise 10 oder 20 willkürlich ausgewählten elektrischen Vorrichtungen 10 aus einem größeren Fertigungslos gemessen. Bei einer nicht zu hohen Fehlerquote weisen davon typischerweise nur eine bis allerhöchstens drei der elektrischen Vorrichtungen 10 denselben Fehler auf, so dass die Messwerte derjenigen elektrischen Vorrichtungen 10, die für eine bestimmte Messung mehrheitlich dieselben Messergebnisse liefern, repräsentativ für solche elektrische Vorrichtungen 10 sind, die zumindest für die bestimmte Messung Messwerte liefern, die für die bestimmte Messung 110 als Sollmesswerte für alle elektrischen Vorrichtungen 10 zugrunde zu legen sind. Dieses Verfahren zur Ermittlung der Sollmesswerte für eine bestimmte Messung kann für alle zu prüfenden Äquipotentialkörperanordnungen 132, d.h. durchzuführenden Messungen 110, angewendet werden.

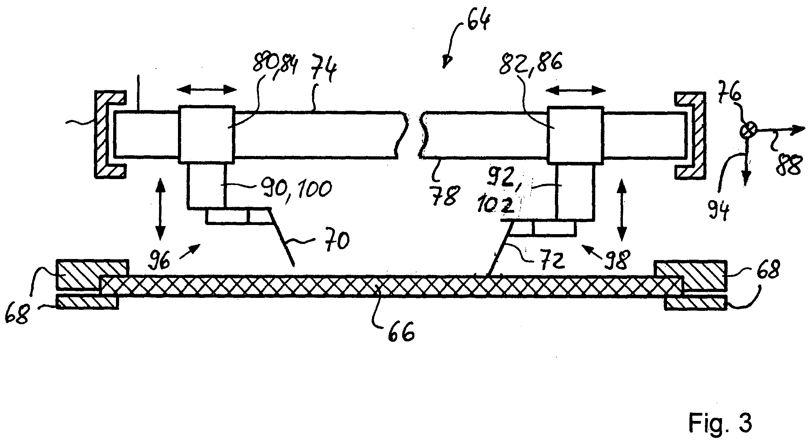

Figur 3 zeigt eine schematische nichtmaßstäbliche seitliche Querschnittsansicht durch eine beispielhafte Messvorrichtung 64 zum Durchführen von Messungen 110 elektrischer Messgrößen C an mehreren elektrischen Vorrichtungen 10. Die elektrische Vorrichtung 10 kann beispielsweise auch eine Leiterplatte 66 sein. Die Figur zeigt, wie eine solche elektrische Vorrichtung 64 in eine Messhalterung 68 eingespannt ist. Außerdem zeigt die Figur zwei Messfühler 70, 72, wobei jeder Messfühler 70, 72 jeden Anschluss- oder Messpunkt 46, 48, 60 zumindest einer Teilmenge von an die Oberfläche 58 der elektrischen Vorrichtung 10 herausgeführten Anschluss- bzw. Messpunkten 46, 48, 60 programmgesteuert positioniert werden kann. Die Messvorrichtung 10 kann eine erste Traverse 74 mit dem ersten Messfühler 70 aufweisen, wobei die erste Traverse 74 programmgesteuert mittels eines (in der Figur nicht dargestellten) Antriebs in einer ersten Richtung 76 (x-Richtung, die in die Papierebene hineinzeigt) hin- und herbewegt werden kann. Außerdem kann die Messvorrichtung 64 eine gleichartige zweite Traverse 78 mit dem zweiten Messfühler 72 aufweisen. Der jeweilige Messfühler 72 ist auf der jeweiligen Traverse 74, 78 auf einem Schlitten 80 bzw. 82 mittels eines Antriebs 84 bzw. 86 programmgesteuert in einer zweiten Richtung 88 (y-Richtung) positionierbar. Eine Herstellung des elektrischen Kontaktes zwischen dem Messfühler 70 bzw. 72 und einem bestimmten Anschluss 46, 48, 60 der elektrischen Vorrichtung 10 erfolgt mittels eines auf dem Schlitten 80 bzw. 82 befestigten programmgesteuerten Antriebs 90 bzw. 92 für eine dritte Bewegungsrichtung 94 (z-Richtung). Eine erste Weiterbildung der Messvorrichtung 64 sieht alternativ oder zusätzlich einen programmgesteuerten Kippantrieb 96 bzw. 98 für den Messfühler 70 bzw. 72 auf, so dass er aufgrund einer kleinen bewegten Masse besonders schnell einen elektrischen Kontakt zu dem jeweiligen Anschluss 46, 48, 60 herstellen und wieder trennen kann. Eine zweite Weiterbildung der Messvorrichtung 64 sieht zusätzlich einen programmgesteuerten Drehantrieb 100 bzw. 102 auf. So können mit einem Messfühler 70 bzw. 72 aus einer Traversenposition heraus mehr Anschlüsse 46, 48, 60 der elektrischen Vorrichtung 10 kontaktiert werden. Für eine Zweipolmessung sind zwei Messfühler 70, 72 mit zwei Ausgängen einer Messelektronik 105 verbunden, wobei die Messelektronik 105 typischerweise eine Messwechselspannungs- oder Messwechselstromquelle 130 und ein elektronisches Messgerät 138 zur Erfassung der zu messenden elektrischen Größe, wie einer Kapazität C oder eines Imaginärteils eines Leitwerts G, umfasst.

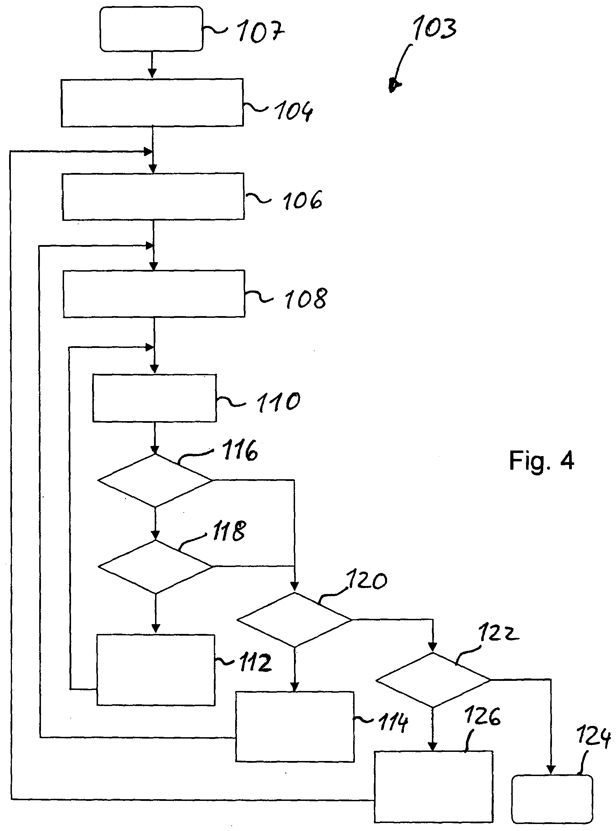

Figur 4 zeigt ein beispielhaftes Ablaufdiagramm zur Erläuterung des erfindungsgemäßen Verfahrens 103 zur Ermittlung elektrischer Eigenschaften mehrerer elektrischer Vorrichtungen 10. Die Aufgabe, einen Fehler oder eine Fehlerfreiheit einer elektrischen Vorrichtung festzustellen, steht häufig im Zusammenhang mit der Lokalisierung des Fehlerortes. Um die Übersichtlichkeit zu erhalten, konzentriert sich diese Beschreibung auf die Aufgabe, einen Fehler oder eine Fehlerfreiheit einer elektrischen Vorrichtung festzustellen und befasst sich nicht so intensiv mit der verwandten Aufgabenstellung, einen Fehlerort zu lokalisieren. Nach einem Programmstart 107, werden in Initialisierungsschritten 104, 106, 108 für eine erste Messung 110 zunächst eine erste Vorrichtung 10, davon ein erster Äquipotentialkörper 20 und davon ein erster Anschluss 46 ausgewählt. Dann wird an dem gewählten Anschluss 46 eine erste elektrische Messung 110 durchgeführt, wobei die erste Messung 110 mehrere gleiche und/oder unterschiedliche Einzelmessungen umfassen kann. Beispielsweise kann eine Kapazität C der Äquipotentialkörperanordnung 132 bei unterschiedlichen Frequenzen fₒ und/oder gegenüber unterschiedlichen zweiten Äquipotentialkörpern 26, 35 gemessen werden. Falls damit bereits alle an dem Äquipotentialkörper 20 durchzuführenden Messungen 110 durchgeführt wurden, wird geprüft, ob noch Messungen 110 an einem anderen Äquipotentialkörper 26, 35 durchzuführen sind (Schritt 120). Ist dies der Fall, so wird dafür ein weiterer Äquipotentialkörper 26, 35 ausgewählt (Schritt 114) und von diesem wiederum ein erster Anschluss 48 für die nächste Messung 110 ausgewählt (Schritt 108). Falls noch nicht alle an dem ersten Äquipotentialkörper 20 durchzuführenden Messungen 110 durchgeführt wurden (Schritt 116), wird geprüft, ob durch eine weitere Messung 110 an dem ersten Äquipotentialkörper 20 an einem anderen Anschluss 60 ein zusätzlicher Erkenntnisgewinn über die Fehlerfreiheit des Äquipotentialkörpers 20 zu erwarten ist (Schritt 118). Die Frage, ob durch eine weitere Messung ein zusätzlicher Erkenntnisgewinn zu erwarten ist, wird vorzugsweise damit beantwortet, dass festgestellt wird, ob ein äquipotentialkörperspezifischer prozentualer minimaler Fehler größer ist als ein prozentualer Messfehler der Messelektronik 105 (der hier verwendete Begriff des minimalen Fehlers wird weiter unten definiert). Falls dies nicht der Fall ist, ist mit einer weiteren Messung ein zusätzlicher Erkenntnisgewinn zu erwarten, und es wird ein nächster Anschluss 60 desselben Äquipotentialkörpers 20 ausgewählt (Schritt 112) und eine weitere Messung durchgeführt (Schritt 110). Ansonsten wird ein weiterer Äquipotentialkörper 26, 35 ausgewählt (Schritt 114) und von diesem wiederum ein erster Anschluss 48 für die nächste Messung 110 ausgewählt (Schritt 108). Bevor ein nächster Äquipotentialkörper 26, 35 ausgewählt wird (Schritt 114), wird allerdings zunächst geprüft, ob bereits Messungen 110 an allen Äquipotentialkörpern 20, 26, 35 (der in Prüfung befindlichen elektrischen Vorrichtung 10) durchgeführt wurden (Schritt 120). Falls dies der Fall ist, wird geprüft, ob bereits alle durchzumessenden elektrischen Vorrichtungen 10 durchgemessen wurden (Schritt 122). Falls dies der Fall ist, werden ggf. Abschlussarbeiten durchgeführt und dann die Durchführung des Messverfahrens 103 angehalten (Schritt 124). Ansonsten werden eine nächste elektrische Vorrichtung 10, davon ein erster Äquipotentialkörper 20 und davon ein erster Anschluss 46 zur Fortsetzung der Messungen 110 ausgewählt (Schritte 126, 106, 108).

Figur 5 zeigt ein Ersatzschaltbild zur Erläuterung eines ersten Konzepts des erfindungsgemäßen Verfahrens am Beispiel einer Zweipolmessung 110. Hierbei wird mit einer Wechselstromquelle 130 ein Wechselstrom lₒ bestimmter Stärke und Frequenz fₒ auf eine Anordnung 132 von zwei Äquipotentialkörpern 20, 26 eingeprägt. In dem Zwischenraum 134 zwischen den beiden Äquipotentialkörpern 20, 26 befindet sich ein weitgehend elektrisch isolierendes Dielektrikum 136, so dass das Gebilde 20, 136, 26 bestehend aus den beiden Äquipotentialkörpern 20, 26 und dem Dielektrikum 136 eine Kapazität C20 darstellt. Diese Kapazität C20 weist für den eingeprägten Wechselstrom lₒ einen bestimmten Wechselstromleitwert G auf, der einen elektrischen Potentialunterschied Um zwischen den beiden Äquipotentialkörpern 20, 26 bestimmt. Der Potentialunterschied Um zwischen den beiden Äquipotentialkörpern 20, 26 wird mittels eines Spannungsmessgeräts 138 gemessen. Aus der Größe lₒ des eingeprägten Wechselstroms lₒ und der Höhe des gemessenen Spannungsabfalls Um kann mittels eines nachgeschalteten Messcomputers 164 gemäß der Formel G = lo/Um der Wechselstromleitwert G der Äquipotentialkörperanordnung 20, 26 berechnet werden. Aus dem Wechselstromwiderstand G und der Frequenz fₒ des eingeprägten Stroms lₒ wiederum lässt sich mittels der Formel C = G/(2π · fₒ) die Kapazität C der Äquipotentialkörperanordnung 20, 26 berechnen. Es versteht sich, dass die Wechselstromquelle lₒ typischerweise eine Spannungsbegrenzung aufweist, damit es nicht zu Beschädigungen der Messanordnung 140, 142 durch eine Überspannung kommt.

Bei niedrigen Kapazitäten C20, die beispielsweise im Pico- oder Femtofaradbereich liegen, sollte eine dazu passend hohe Frequenz fₒ verwendet werden, um Spannungswerte Um in einem für die Messung 110 noch geeigneten Spannungsbereich zu erhalten. Da innerhalb eines jeden Äquipotentialkörpers 20, 26 ein Potentialausgleich stattfindet, wären bei nicht allzu hohen Frequenzen fₒ von bis zu etwa 1 MHz und bei einem fehlerfreien Äquipotentialkörper 20, 26 mit ausreichender Leitfähigkeit und einer fehlerfreien Kontaktierung der Messfühler 70 bei Anlegen des Messfühlers 70 an unterschiedliche Anschlüsse 46, 60 des Äquipotentialkörpers 20 keine unterschiedlichen Messergebnisse zu erwarten. D.h. die ermittelte Kapazität C20 der Äquipotentialkörperanordnung 132 wäre immer gleich hoch. Je höher die Frequenz fₒ ist, desto mehr entspricht die elektromagnetische Wellenlänge der Größenordnung der Ausdehnung der Äquipotentialkörper 20, 26 und desto mehr verhält sich die Äquipotentialkörperanordnung 132 wie ein Wellenleiter 132. D.h. der Potentialausgleich im Äquipotentialkörper 20, 26 findet mit der Geschwindigkeit statt, mit der sich die hochfrequente elektromagnetische Welle in dem durch die beiden Äquipotentialkörper 20, 26 gebildeten Wellenleiter 132 ausbreiten kann. In diesem Fall können an unterschiedlichen Anschlüssen 46, 60 des Äquipotentialkörpers 20 auch bei einem fehlerfreien und nicht kurzgeschlossenen Äquipotentialkörper 20 durchaus ganz unterschiedliche Spannungsabfälle Um gemessen werden. Beispielsweise würde eine Messung 110 an einem Wellenknoten eine Spannung Um von null Volt liefern, was nach obigen Formeln einem unendlich hohen Kapazitätswert entsprechen würde.

Im Folgenden wird nun vorausgesetzt, dass die verwendete Frequenz fₒ niedrig genug ist, um das beschriebene Verhalten der Äquipotentialkörperanordnung 132 als Wellenleiter 132 zu vernachlässigen. Bei einer intakten Äquipotentialkörperanordnung 132 würde die Messung 110 dann an allen Anschlüssen 46, 60 desselben Äquipotentialkörpers 20 immer den gleichen Kapazitätswert C20 liefern. Im Falle eines fehlerfreien Äquipotentialkörpers 20 liefert also grundsätzlich nur die erste Messung 110 an irgendeinem der Anschlüsse 46, 60 einen Erkenntnisgewinn. Denn unter den genannten Voraussetzungen sind die gemessenen Werte an den anderen Anschlüssen 60 bzw. 46 sowieso identisch. Dies gilt allerdings dann nicht, wenn der Äquipotentialkörper 20 eine Unterbrechung oder einen Leitfähigkeitsfehler aufweist. In diesem Fall sind die gemessenen Werte Um an den Anschlüssen 46, 60 auf der einen Seite der Unterbrechung beziehungsweise des Leitfähigkeitsfehlers unterschiedlich zu denen auf der anderen Seite der Unterbrechung beziehungsweise des Leitfähigkeitsfehlers. Deshalb wurden in konventionellen Verfahren sicherheitshalber an allen Anschlüssen 46, 60 des Äquipotentialkörpers 20 eine Messung 110 durchführt, woraus ein hoher Zeitaufwand für die Durchführung aller erforderlichen Messungen 110 resultiert. Erfindungsgemäß wird je Äquipotentialkörper 20, 26, 35 nur eine Kapazitätsmessung 110 durchgeführt, sofern diese bereits eine ausreichende Aussagekraft für eine Fehlerfreiheit des Äquipotentialkörpers 20 liefert. Es wird hierbei die Tatsache ausgenutzt, dass sich eine Unterbrechung oder ein Leitfähigkeitsfehler des Äquipotentialkörpers 20 immer irgendwie auf die mit dem zweiten Äquipotentialkörper 26 gebildete und gemessene Gesamtkapazität C20 + C26 auswirkt und zwar unabhängig davon, in welchem Bereich des Äquipotentialkörpers 20 die Unterbrechung oder der Leitfähigkeitsfehler besteht. Könnte die Messung 110 des Istwerts der Kapazität C20 der Äquipotentialkörperanordnung 132 toleranzfrei erfolgen und wäre der Sollwert der Kapazität C20 der Äquipotentialkörperanordnung 132 toleranzfrei, dann würde - aufgrund des Ladungsausgleichs im Äquipotentialkörper 20 - immer eine einzige Kapazitätsmessung 110 ausreichen, um eine sichere Aussage darüber geben zu können, ob der angemessene Äquipotentialkörper 20 fehlerfrei ist. In der Praxis liegen hier Mess- und Solltoleranzen allerdings häufig in derselben Größenordung, so dass eine einzelne Messung 110 mitunter nicht ausreicht. Um trotzdem die für alle durchzuführenden Messungen 110 erforderliche Gesamtzeit zu verringern, wird erfindungsgemäß zwischen den Fällen unterschieden, in denen eine einzelne Messung 110 ausreicht und in denen weitere Messungen 110 durchzuführen sind. Bei einem ausgedehnten Äquipotentialkörper 20 hat eine Unterbrechung an einem Rand des Äquipotentialkörpers 20, 26, beispielsweise in der Nähe eines Anschlusses 46 desselben, prozentual gesehen nur einen kleinen Einfluss auf den gemessenen Kapazitätsmesswert der Äquipotentialkörperanordnung 132. Wenn der prozentuale Einfluss dieser Unterbrechung kleiner ist, als eine Toleranz der Kapazitätsmessung, lässt sich der Fehler mit einer einzigen Kapazitätsmessung in der Regel nicht entdecken. Bei einem Äquipotentialkörper 20, der nur eine geringe Ausdehnung aufweist, ist die durch die Unterbrechung am Rand des Äquipotentialkörpers 20 verursachte Messwertveränderung häufig so groß, dass der Fehler mittels nur einer einzigen Kapazitätsmessung zuverlässig feststellbar ist. Um diese beiden Fälle zu unterscheiden, ist es zweckmäßig, die Größe des gerade noch zuverlässig zu entdeckenden Fehlers zu ermitteln, der hier als "minimaler Fehler" bezeichnet wird. Ein "absoluter minimale Fehler", ist beispielsweise die Kapazität, die ein einzelner Anschluss aufweist, der von seinem Äquipotentialkörper "abgebrochen" ist. Ein "prozentualer minimaler Fehler" ist beispielsweise das Verhältnis des "absoluten minimalen Fehlers" im Verhältnis zu einer Sollkapazität eines fehlerfreien Äquipotentialkörpers 20. Da letztere von der Ausdehnung des Äquipotentialkörpers 20 abhängig ist, ist der prozentuale minimale Fehler äquipotentialkörperspezifisch. Der minimale absolute Fehler kann an einzelnen ohne Äquipotentialkörper ausgebildeten Anschlüssen 150, 152 gemessen werden oder anhand von CAD- und Materialdaten berechnet bzw. abgeschätzt werden. Unter Berücksichtigung einer aus CAD-Daten berechenbaren oder mittels Kapazitätsmessungen an fehlerfreien Mustern 10 ermittelten Sollkapazität kann für jeden Äquipotentialkörper 20, 26, 35 der spezifische prozentuale minimale Fehler ermittelt werden. Wenn dieser spezifische prozentuale minimale Fehler größer ist als ein prozentualer Messfehler der Messelektronik 105, reicht für eine Feststellung der Fehlerfreiheit des jeweiligen Äquipotentialkörpers 20, 26, 35 eine einzige Messung aus, so dass im Verfahrensschritt 118 zur Auswahl eines nächsten Äquipotentialkörpers verzweigt wird.

Die potentiellen minimalen Fehler, die an bestimmten Anschlüssen des Äquipotentialkörpers gemessen werden können, sind an einzelnen ohne mit dem Äquipotentialkörper verbunden Anschlüssen messbar oder anhand von CAD-Daten und Materialdaten berechenbar bzw. abschätzbar. Sie liegen somit für bestimmte Typen von Anschlüssen vor. Ist die elektrische Vorrichtung eine Leiterplatte, dann können diese Typen von Anschlüsse Durchkontaktierungen mit einer bestimmten Größe und/oder Padflächen mit einer bestimmten Größe sein, deren minimale Fehler alleine durch den Typ des Anschlusses bestimmt sind. So weisen diese Anschlußtypen jeweils eine gewisse Mindestkapazität auf, die bei einer kapazitiven Messung den Mindestfehler darstellen kann.

Figur 6 zeigt ein Ersatzschaltbild zur Erläuterung eines zweiten Konzepts des erfindungsgemäßen Verfahrens 103 am Beispiel einer Zweipolmessung 110. Hierbei wird in den Fällen, in denen der Toleranzbereich für eine Einzelmessung 110 mit einem ersten Äquipotentialkörper 20 noch nicht ausgeschöpft ist, mittels eines dritten Messfühlers 143 und einer elektrischen Brücke 144 im gleichen Messgang eine Gesamtkapazität C20 + C26 des ersten 20 und dritten Äquipotentialkörpers 35 gemessen und damit im gleichen Messgang gleichzeitig auch eine Fehlerfreiheit des dritten Äquipotentialkörpers 35 mitüberprüft.

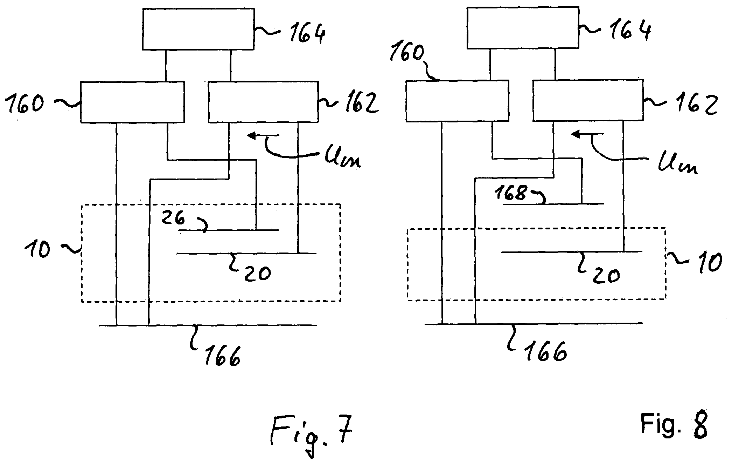

Figur 7 zeigt ein Beispiel für eine Messanordnung für eine Vierpolmessung, wobei ein eingeprägtes elektrisches Feld mittels einer Messspannungsquelle 160 erzeugt wird und eine elektrische Potentialdifferenz Um mittels eines Spannungsmessgeräts 162 erfasst wird. Die Messspannungsquelle 160 kann eine Wechselspannungsquelle für einen periodischen, insbesondere sinusförmigen Spannungsverlauf, sein. Sie kann aber auch eine Spannungsquelle sein, deren Ausgang ein stationäres "Eingangssignal" wie ein Rauschen liefert. Das Spannungsmessgerät 162 kann ein Wechselspannungsmessgerät für einen periodischen, insbesondere sinusförmigen Spannungsverlauf, sein. Es kann aber auch ein Spannungsmessgerät 162 sein, das ein mehrfrequentes oder ein stationäres "Ausgangssignal" wie ein Rauschen im Zeit- oder Frequenzbereich auswerten kann. Im letzteren Fall ist das Spannungsmessgerät 162 typischerweise Spektralanalysator 162. Zur Automatisierung können die Messspannungsquelle 160 und das Spannungsmessgerät 162 bzw. der Spektralanalysator 162 von einem übergeordneten Messcomputer 164 gesteuert werden, der die Messergebnisse in gut handhabbare Größen - wie Kapazitätswerte C20, Fehlerortkoordinaten, Qualitätsbewertungen - umrechnet. In der dargestellten Messanordnung sind die Messspannungsquelle 160 und das Spannungsmessgerät 162 bzw. der Spektralanalysator 162 an einer gemeinsamen Äquipotentialfläche 166 angeschlossen, was aber nicht zwingend ist.

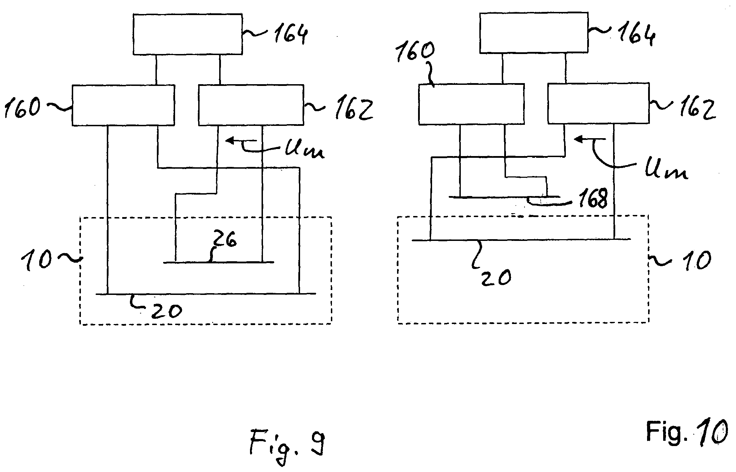

Figur 9 zeigt ein Beispiel für eine Messanordnung für eine Vierpolmessung, wobei der Vierpol als magnetisch gekoppelter Hochfrequenzübertrager betrieben wird. Dazu wird mittels der Messspannungsquelle 160 bzw. mittels der Rauschquelle 160 ein Strom durch zumindest einen Abschnitt des ersten Äquipotentialkörpers 20 eingeprägt. An zwei Anschlüssen des direkt oder mittelbar benachbarten zweiten Äquipotentialkörpers 26 wird mittels des Spannungsmessgeräts 162 bzw. Spektralanalysators 162 eine in dem zweiten Äquipotentialkörper 26 induzierte Spannung Um erfasst.

Die Figuren 8 und 10 unterscheiden sich von der in der jeweils vorausgehenden Figur gezeigten Messanordnung dadurch, dass auch die zweite Äquipotentialfläche 168 zur Erzeugung des eingeprägten elektrischen Feldes eine außerhalb der elektrischen Vorrichtung 10 angeordnete Äquipotentialfläche ist.

### Bezugszeichen:

- 10: elektrische Vorrichtung
- 12: horizontale Richtung
- 14: vertikale Richtung
- 18: nichtleitende Schicht
- 20: erster Äquipotentialkörper (Äquipotentialkörper = ÄPK)
- 22, 24, 25: nichtleitende Schicht
- 26: zweiter Äquipotentialkörper
- 28, 30, 32, 34: nichtleitende Schicht
- 35: dritter Äquipotentialkörper
- 36, 38: nichtleitende Schicht
- 40, 42, 44: Äquipotentialkörper
- 46: elektrischer Anschluss des ersten Äquipotentialkörpers 20
- 48: elektrischer Anschluss des zweiten Äquipotentialkörpers 26
- 50: Durchkontaktierung für zweiten Äquipotentialkörper 26
- 52: Durchkontaktierung für ersten Äquipotentialkörper 20
- 54, 56: Äquipotentialkörper
- 58: Außenseite der elektrischen Vorrichtung 10
- 60: anderer elektr. Anschluss des ersten Äquipotentialkörpers 20
- 62: sternartig verzweigter Äquipotentialkörper
- 64: Messvorrichtung
- 66: Leiterplatte
- 70: erster Messfühler
- 72: zweiter Messfühler
- 74: erste Traverse
- 76: erste Richtung (x-Richtung)
- 78: zweite Traverse
- 80: erster Schlitten
- 82: zweiter Schlitten
- 84: Antrieb für ersten Schlitten
- 86: Antrieb für zweiten Schlitten
- 88: zweite Richtung (y-Richtung)
- 90: erster Antrieb für dritte Bewegungsrichtung
- 92: zweiter Antrieb für dritte Bewegungsrichtung
- 94: dritte Bewegungsrichtung (z-Richtung)
- 96: Kippantrieb für ersten Messfühler 70
- 98: Kippantrieb für zweiten Messfühler 72
- 100: programmgesteuerter Drehantrieb für ersten Messfühler 70
- 102: programmgesteuerter Drehantrieb für zweiten Messfühler 72
- 103: erfindungsgemäßes Verfahren
- 104: Auswahl einer ersten Vorrichtung
- 105: Messelektronik
- 106: Auswahl eines ersten Äquipotentialkörpers
- 107: Programmstart
- 108: Auswahl eines ersten Anschlusses
- 110: Messung
- 114: Auwahl eines weiteren Äquipotentialkörpers
- 116: Prüfung ob alle an dem ÄPK durchzuführenden Messungen durchgeführt wurden
- 118: Prüfung ob Messung an einem anderen Anschluss einen zusätzlichen Erkenntnisgewinn verspricht
- 120: Prüfung ob alle zu prüfenden ÄPK angemessen wurden
- 122: Prüfung ob alle zu prüfenden elektr. Vorrichtungen angemessen wurden
- 124: Stopp des Verfahrens
- 126: Auswahl einer nächsten Vorrichtung
- 130: Wechselstromquelle
- 132: Äquipotentialkörperanordnung; Wellenleiter
- 134: Zwischenraum zwischen den Äquipotentialkörpern
- 136: Dielektrikum
- 138: Spannungsmessgerät; Spektralanalysator
- 140: Messanordnung
- 142: Messanordnung
- 143: dritter Messfühler
- 144: elektrisches Bauelement zum temporären Verbinden
- 150: Äquipotentialkörper mit beispielhaften Abmessungen
- 152: Äquipotentialkörper mit beispielhaften Abmessungen
- 160: Messspannungsquelle; Rauschgenerator
- 162: Spannungsmessgerät; Spektralanalysator
- 164: Messcomputer

- C: elektrische Messgröße
- C20: Kapazität des Äquipotentialkörpers 20
- C26: Kapazität des Äquipotentialkörpers 26
- fₒ: Messfrequenz
- G: komplexer Leitwert
- lₒ: eingeprägter Wechselstrom
- Uₘ: Messspannung

## Patentansprüche

1. Verfahren (103) zur Ermittlung elektrischer Eigenschaften einer elektrischen Vorrichtung (10), wobei das Verfahren (103) folgende Schritte umfasst:
a) Bereitstellen für jeden Äquipotentialkörper der elektrischen Vorrichtung (10) eines spezifischen minimalen Fehlers, wobei dieser minimale Fehler die Größe eines gerade noch zuverlässig zu erkennenden Fehlers eines jeweiligen Äquipotentialkörpers (20,26) darstellt und äquipotentialkörperspezifisch ist,
b) Durchführen zumindest einer Messung (110) einer elektrischen Messgröße an mindestens einem herausgeführten elektrischen Anschluss (46,48) eines jeden von mehreren Äquipotentialkörpern (20,26) der elektrischen Vorrichtung (10), und
c) Entscheiden, dass die Messung (110) der elektrischen Messgröße (C) bestimmter Äquipotentialkörper (20,26) an zumindest einem anderen herausgeführten elektrischen Anschluss (60) des jeweiligen Äquipotentialkörpers (20,26) nicht durchgeführt wird, wenn der ermittelte, spezifische minimale Fehler des jeweiligen Äquipotentialkörpers (20,26) im Bereich dieses anderen Anschlusses (60) die elektrische Messgröße (C) stärker beeinflusst als eine Toleranz der Messung dieser Messgröße (C) beträgt.

2. Verfahren (103) gemäß Anspruch 1, wobei eine Höhe der Beeinflussung der elektrischen Messgröße (C) während einer Durchführung des Verfahrens (103) mittels Messungen an einer repräsentativen Anzahl von gleichartigen elektrischen Vorrichtungen (10) statistisch ermittelt wird.

3. Verfahren (103) gemäß Anspruch 1 oder 2, wobei eine für die Messungen zugrundezulegende Messtoleranz mittels einer Eichmessung an mindestens einem Äquipotentialkörper (150, 152) mit beispielhaften Abmessungen ermittelt wird.

4. Verfahren (103) gemäß Anspruch 1 bis 3, wobei zunächst erste Messungen (110) unter Zugrundelegung einer Anfangsmesstoleranz durchgeführt werden und für nachfolgende Messungen eine aus den ersten Messungen (110) statistisch ermittelte Messtoleranz zugrundegelegt wird.

5. Verfahren (103) gemäß einem der Ansprüche 1 bis 4, wobei während einzelner Messungen (110) jeweils zwischen zwei oder mehr Äquipotentialkörpern (20, 26) mittels eines elektrischen Bauelements (144) eine temporäre elektrische Verbindung hergestellt wird und an den jeweils temporär elektrisch verbundenen Äquipotentialkörpern (20, 26) eine gemeinsame Messung (110) durchgeführt wird.

6. Verfahren (103) gemäß Anspruch 5, wobei das elektrische Bauelement (144) im Wesentlichen eine elektrische Leitung bildet.

7. Verfahren (103) gemäß einem der Ansprüche 1 bis 6, wobei die Messungen (110) Leitwert- und/oder Kapazitäts- und/oder Laufzeitmessungen und/oder elektrische Feldmessungen und/oder magnetische Feldmessungen und/oder elektromagnetische Feldmessungen umfassen.

8. Verfahren (103) gemäß einem der Ansprüche 1 bis 7, wobei die Messungen (110) eine Messung eines Betrags, eines Winkels, eines Realteils und/oder eines Imaginärteils eines Vierpolparameters der Leitwertform, der Widerstandsform, der Kettenform und/oder der Hybridform umfasst.

9. Verfahren (103) gemäß einem der Ansprüche 1 bis 8, wobei ein Sollwert eines Messwerts der Messung und/oder eine Toleranz des Messwerts der Messung während einer Durchführung des Verfahrens mittels Messungen (110) an einer repräsentativen Anzahl von gleichartigen elektrischen Vorrichtungen (10) statistisch ermittelt wird.

10. Verfahren (103) gemäß einem der Ansprüche 1 bis 9, wobei während der Messung (110) zumindest zeitweise und zumindest raumabschnittsweise die elektrische Vorrichtung (10) einem elektrischen, einem magnetischen und/oder einem elektromagnetischen Feld ausgesetzt wird.

11. Verfahren (103) gemäß Anspruch 10, wobei das Feld ein inhomogenes Feld und/oder ein zumindest zeitweise stationäres Feld und/oder ein zumindest zeitweise nichtstationäres Feld ist.

12. Verfahren (103) gemäß einem der Ansprüche 10 bis 11, wobei mindestens einer der Äquipotentialkörper (20, 26) der elektrischen Vorrichtung (10) an eine Strom- oder Spannungsquelle (130) angeschlossen wird, um das elektrische und/oder elektromagnetische Feld zu erzeugen.

13. Verfahren (103) gemäß einem der Ansprüche 1 bis 12, wobei eine Höhe der Beeinflussung der elektrischen Messgröße von einer Volumenausdehnung und/oder von einer Flächenausdehnung und/oder von einer Längenausdehnung und/oder von einer spezifischen Leitfähigkeit und/oder von einer Kontaktstellenzahl und/oder von einer Prüfpunktzahl und/oder von einer Bohrungszahl des jeweiligen Äquipotentialkörpers (20, 26) und/oder von einem den jeweiligen Äquipotentialkörper (20, 26) umgebenden Material (136) abhängig ist.

14. Verfahren gemäß einem der Ansprüche 1 bis 13, wobei zunächst geprüft wird, ob ein gegebenenfalls zu erkennender Fehler des jeweiligen Äquipotentialkörpers (20, 26) im Bereich dieses anderen Anschlusses (60) die elektrische Messgröße (C) stärker beeinflusst als eine Toleranz der Messung dieser Messgröße (C) beträgt, und falls dies der Fall ist, keine Messung an diesem weiteren Anschluss durchgeführt wird, wobei die Prüfung vor Durchführung der ersten Messung der Messgrößen erfolgt.

15. Vorrichtung (64) zur Ermittlung elektrischer Eigenschaften einer elektrischen Vorrichtung (10),
**dadurch gekennzeichnet,**
**dass** die Vorrichtung (64) zur Ermittlung elektrischer Eigenschaften zum Ausführen eines Verfahrens (103) gemäß einem der vorausgehenden Ansprüche ausgebildet ist.

## Claims

1. Method (103) of determining the electrical properties of an electrical device (10), wherein the method (103) comprises the following steps:
(a) provision of a specific minimal error for each equipotential body of the electrical device (10), wherein the minimal error represents the dimension of an error that is just still reliably determinable of a respective equipotential body (20, 26) and is specific for an equipotential body,
(b) taking of at least one measurement (110) of an electrical measured quantity at one or more brought-out electrical connections (46, 48) of each of several equipotential bodies (20, 26) of the electrical device (10),
(c) deciding that the measurement (110) of the electrical measured quantity (C) of certain equipotential bodies (20, 26) on at least one other brought-out electrical connection (60) of the equipotential body (20, 26) concerned is not performed, if the detected specific minimal error of the respective equipotential body (20, 26) in the area of this other connection (60) influences the electrical measured quantity (C) more strongly than a tolerance of the measurement of this measured quantity (C).

2. Method (103) according to claim 1, wherein a level of influencing of the electrical measured quantity (C) during execution of the method (103) is determined statistically by means of a measurement on a representative number of similar electrical devices (10).

3. Method (103) according to claim 1 or 2, wherein a measuring tolerance to be used as a basis for the measurements is determined by means of a calibration measurement on at least one equipotential body (150, 152) with exemplary dimensions.

4. Method (103) according to claims 1 to 3, wherein initial measurements (110) are made on the basis of an initial measuring tolerance, with a measuring tolerance statistically determined from the first measurements (110) being used for subsequent measurements.

5. Method (103) according to any of claims 1 to 4, wherein during individual measurements (110) in each case between two or more equipotential bodies (20, 26), a temporary electrical connection is created by means of an electrical component (144) and a joint measurement (110) is made on the temporarily electrically connected equipotential bodies (20, 26).

6. Method (103) according to claim 5, wherein the electrical component (144) substantially forms an electrical conductor.

7. Method (103) according to any of claims 1 to 6, wherein the measurements (110) may include conductance and/or capacitance and/or propagation time measurements, and/or electrical field measurements and/or magnetic field measurements and/or electromagnetic field measurements.

8. Method (103) according to any of claims 1 to 7, wherein the measurements (110) include the measurement of an amount, an angle, a real component and/or an imaginary component of a four-pole parameter of the conductance form, the resistance form, the chain form and/or the hybrid form.

9. Method (103) according to any of claims 1 to 8, wherein a set value of a measured value of the measurement and/or a tolerance of the measured value of the measurement during implementation of the method are determined statistically by means of measurements (110) on a representative number of similar electrical devices (10).

10. Method (103) according to any of claims 1 to 9, wherein during measurement (110), the electrical device (10) may be subjected to an electrical, a magnetic and/or an electromagnetic field, at least for a time and at least in some areas.

11. Method (103) according to claim 10, wherein the field is an inhomogeneous field and/or a field which is stationary for at least part of the time and/or a field which is not stationary for at least part of the time.

12. Method (103) according to any of claims 10 to 11, wherein at least one of the equipotential bodies (20, 26) of the electrical device (10) is connected to a current or voltage supply (130), in order to generate the electrical and/or electromagnetic field.

13. Method (103) according to any of claims 1 to 12, wherein the level of influence on the electrical measured quantity is dependent on an expansion of volume and/or an expansion in area and/or and extension of length and/or on a specific conductivity and/or on a number of contact points and/or on a number of test points and/or on a number of holes in the equipotential body (20, 26) concerned and/or on a material (136) encompassing the equipotential body (20, 26) concerned.

14. Method (103) according to any of claims 1 to 13, wherein a test is first made to determine whether error, which it may be appropriate to detect, of the equipotential body (20, 26) in the area of this other connection (60), influences the electrical measured quantity (C) more strongly than a tolerance of the measurement of this measured quantity (C) and, if this is the case, no measurement is made at this other connection, while the test is made before performing the first measurement of the measured quantities.

15. Device (64) for determining electrical properties of an electrical device (10), **characterised in that**
the device (64) for determining electrical properties is realised for the carrying out of a method (103) according to any of the preceding claims.

## Revendications

1. Procédé (103) pour la détection de propriétés électriques d'un dispositif électrique (10), dans lequel le procédé (103) comprend les étapes suivantes :
a) la prévision, pour chaque corps de potentiel équivalent du dispositif électrique (10), d'une erreur minimale, dans lequel cette erreur minimale représente la dimension d'une erreur pouvant juste encore être fiablement détecté d'un corps de potentiel équivalent respectif (20, 26) et est spécifique pour le corps de potentiel équivalent,
b) la réalisation d'au moins une mesure (110) d'une dimension de mesure électrique sur au moins un contact électrique mené vers l'extérieur (46, 48) de chacun de plusieurs corps de potentiel équivalent (20, 26) du dispositif électrique (10), et
c) la décision, que la mesure (110) de la dimension de mesure électrique (C) de certains corps de potentiel équivalent (20, 26) à au moins un autre contact électrique mené vers l'extérieur (60) du corps de potentiel équivalent respectif (20, 26) n'est pas effectuée, si l'erreur minimale spécifique détectée du corps de potentiel équivalent (20, 26) respectif influence la dimension de mesure électrique (C) dans la zone de cet autre contact (60) plus qu'une tolérance de la mesure de cette dimension de mesure (C).

2. Procédé (103) selon la revendication 1, dans lequel une ampleur de l'influence de la dimension de mesure électrique (C) est statistiquement détectée durant une réalisation du procédé (103) par le moyen de mesure à un nombre représentatif de dispositifs électriques (10) de même type.

3. Procédé (103) selon la revendication 1 ou 2, dans lequel une tolérance de mesure sur laquelle doivent se fonder les mesures est détectée par les moyens d'une mesure d'étalonnage à au moins un corps de potentiel équivalent (150, 152) ayant des dimensions exemplaires.

4. Procédé (103) selon la revendication 1 à 3, dans lequel d'abord des premières mesures (110) se fondant sur une tolérance de mesure de début sont effectués, des mesures subséquentes se fondant sur une tolérance de mesure statistiquement déterminée à partir des premières mesures (110).

5. Procédé (103) selon l'une des revendications 1 à 4, dans lequel durant chaque mesure (110) respectivement entre deux ou plusieurs corps de potentiel équivalent (20, 26) une connexion électrique temporaire est faite par le moyen d'un élément de construction électrique (144), et une mesure (110) collective est effectuée au corps de potentiel équivalent (20, 26) respectivement temporairement électriquement connectées.

6. Procédé ouvrir parenthèse 103) selon la revendication 5, dans lequel l'élément de construction électrique (144) forme substantiellement une liaison électrique.

7. Procédé (103) selon l'une des revendications 1 à 6, dans lequel les mesures (110) comprennent des mesures de valeur de guidage et/ou de capacité et/ou de durée et ou des mesures de champ électrique et/ou des mesures de champ magnétique et/ou des mesures de champ électromagnétique.

8. Procédé (103) selon l'une des revendications 1 à 7, dans lequel les mesures (110) comprennent une mesure du taux, d'un angle, d'une partie réale et/ou d'une partie imaginaire d'un paramètre quadripôle de la forme de la valeur de guidage, de la forme de résistance, de la forme de chaîne et/ou de la forme hybride.

9. Procédé (103) selon l'une des revendications 1 à 8, dans lequel une valeur prévue d'une valeur de mesure de la mesure et/ou une tolérance de la valeur de mesure de la mesure sont statistiquement détectées durant une réalisation du procédé par le moyen de mesure (110) à un nombre représentatif de dispositifs électriques (10) du même type.

10. Procédé (103) selon l'une des revendications à 9, dans lequel, durant la mesure (110), au moins temporairement et au moins par rapport à une partie spatiale, le dispositif électrique (10) est soumis à un champ électrique, à un champ magnétique et/ou à un champ électromagnétique.

11. Procédé (103) selon la revendication 10, dans lequel le champ est un champ inhomogène et/ou un champ au moins temporairement stationnaire et/ou un champ au moins temporairement non stationnaire.

12. Procédé (103) selon l'une des revendications 10 à 11, dans lequel au moins un corps de potentiel équivalent (20, 26) du dispositif électrique (10) est connecté à une source de courant ou de tension (132) pour créer le champ électrique et/ou électromagnétique.

13. Procédé (103) selon l'une des revendications 1 à 12, dans lequel un taux d'influence de la valeur de mesure électrique dépend d'une extension de volume et/ou d'une extension de surface et/ou d'une extension de longueur et/ou d'une conductivité spécifique et/ou d'un nombre de points de contact et/ou d'un nombre de points d'examen et/ou d'un nombre de forages du corps de potentiel équivalent (20, 26) respectif et/ou d'un matériau entourant (136) le corps de potentiel équivalent (20, 26) respectif.

14. Procédé selon l'une des revendications 1 à 13, dans lequel on examine d'abord si une erreur éventuellement détectable du corps de potentiel équivalent (20, 26) respectif dans la zone de cet autre contact (60) influence la valeur de mesure électrique (C) plus qu'une tolérance de mesure de cette valeur de mesure (C), et si c'est le cas, aucune mesure est effectuée à ce contact additionnel, l'examen étant effectué avant la réalisation de la première mesure des valeurs de mesure.

15. Dispositif (64) pour la détection de propriétés électriques d'un dispositif électrique (10),
**caractérisé par** ce que le dispositif (64) pour la détection de propriétés électriques est réalisé pour effectuer un procédé (103) selon l'une quelconque des revendications précédentes.
